# EUROPEAN PATENT APPLICATION

(11) **EP 1 978 551 A1**
(43) Date of publication of application: **08.10.2008**
(21) Application number: 08001445.9
(22) Date of filing: 25.01.2008
(51) Int. Cl.: H01L 21/48, H01L 23/498, H01L 23/31

(54) **Substrate for thin chip packagings**

(30) Priority: 03.04.2007 TW 96205417 U
(71) Applicant: Biar, Jeff, Hsinchu City 300 (TW); Huang, Chih-Kung, Hsinchu City 300 (TW)
(72) Inventor: Biar, Jeff, Hsinchu City 300 (TW); Huang, Chih-Kung, Hsinchu City 300 (TW)
(74) Representative: Straus, Alexander

(57) **Abstract**

A substrate (10) for chip packaging comprises a carrier layer (12), an etching stopper (14) and an active layer (16). The carrier layer (12) is made of a conductive metal sheet with a predetermined thickness. The etching stopper (14) is disposed on a side of the carrier layer (12). The active layer (16) is made of conductive metal materials and disposed on a free side of the etching stopper (14) in a wiring pattern formed by an etching process operating on the active layer (16).

## Description

### BACKGROUND OF THE INVENTION

### 1. Field of the Invention

The present invention is generally related to chip packagings, and more particularly, to a substrate for thin chip packagings.

### 2. Description of the Related Art

It is well known that the conventional substrates for chip packaging are mostly made of glass fibers mixed with epoxy resin. For preventing from being deformed or destroyed during chip packaging process, such as punching, drilling, curing or molding, the substrate must be provided in a thick form. As a result, the chip packaging with such a prior art substrate can not be made thinner. In addition, the prior art substrate will be deformed as the working temperature is over 200 °C.

### SUMMARY OF THE INVENTION

Accordingly, an object of the present invention is to provide a substrate which can be in a thinner form to be used in thin chip packagings.

An other object of the present invention is to provide an improved substrate for chip packaging which would not be deformed as the working temperature is over 200 °C.

To achieve these objects, a substrate for chip packaging, according to one aspect of the present invention, comprises a carrier layer, an etching stopper and an active layer. The carrier layer is made of a conductive metal sheet with a predetermined thickness. The etching stopper is disposed on a side of the carrier layer. The active layer is made of conductive metal materials and disposed on a free side of the etching stopper in a wiring pattern formed by an etching process operating on the active layer.

### BRIEF DESCRIPTION OF THE DRAWINGS

The above and other objects, advantages and features of the present invention will be more apparent from the following description taken in conjunction with the accompanying drawings in which:
FIG. 1 is a schematic perspective view of a first preferred embodiment according to the present invention;
FIG. 2 is a cross-sectional view of the substrate of FIG. 1 taken along line 2-2;
FIG. 3 is a schematic perspective view of a chip packaging with the substrate of FIG. 1;
FIG. 4 is a cross-sectional view of a second preferred embodiment according to the present invention; and
FIG. 5 is a cross-sectional view of a third preferred embodiment according to the present invention.

### DETAILED DESCRIPTION OF THE INVENTION

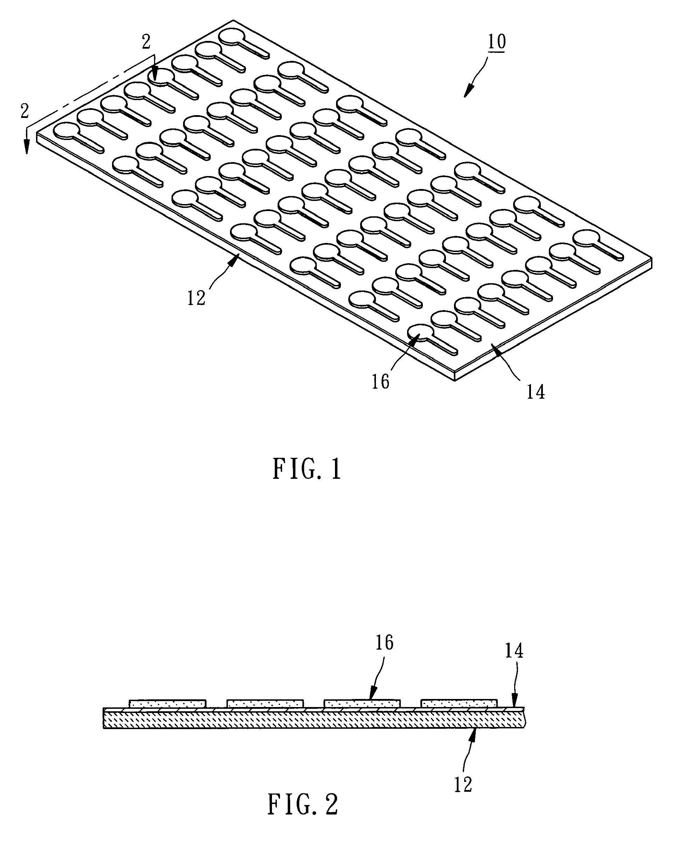

Referring firstly to FIGS. 1-3, the drawings illustrate a first preferred embodiment according to one aspect of the present invention. In the drawings, reference numeral 10 denotes a substrate, which comprises a carrier layer 12, an etching stopper 14 and an active layer 16.

Carrier layer 12 is made of a copper sheet with a predetermined thickness, such as 15-100 µm. It functions as a supporting during packaging processes.

Etching stopper 14 is made of a nickel sheet with a predetermined thickness, such as 0.2-1 µ m. It is disposed on an upper side of carrier layer 12.

Active layer 16 is also made of a copper sheet with a thickness being thinner than that of carrier layer 12, such as 9-18 µ m. Active layer 16 is disposed on a free side of etching stopper 14 in a wiring pattern formed by an etching process operating thereon. Carrier layer 12 and 14 etching stopper are ridded off after all packaging processes are done.

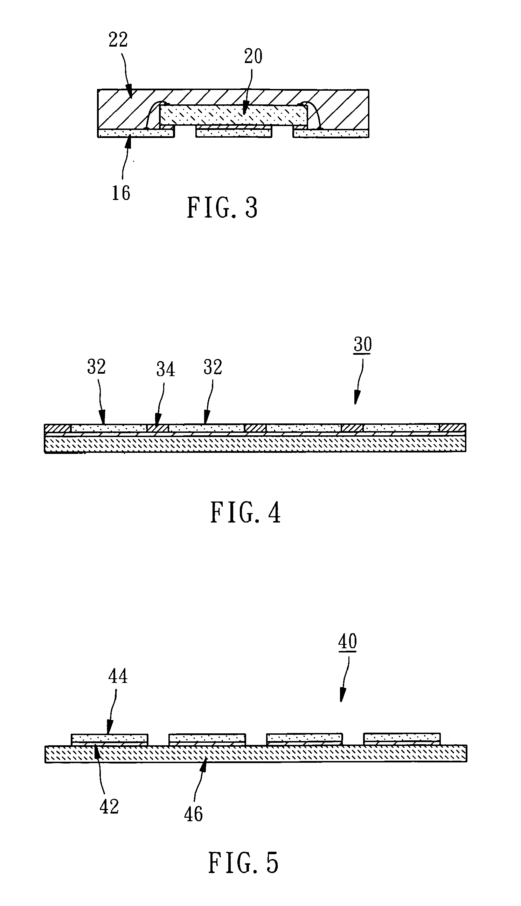

When substrate 10 is used in chip packaging, as shown in FIG. 3, a chip 20 is firstly adhered to an upper side of active layer 16 of substrate 10, and then a wiring bonding and a plastic resin covering processes are proceeded, lastly carrier layer 12 and etching stopper 14 are all removed from substrate 10.

Referring lastly to FIGS. 4 and 5, FIG.4 illustrates a substrate 30 of a second preferred embodiment of the present invention. The difference between substrate 10 and substrate 30 is that the spaces formed in the wiring pattern of active layer 32 of substrate 30 are respectively filled by an insulation material such as a solder mask layer 34.

FIG.5 illustrates a substrate 40 of a third preferred embodiment of the present invention. The difference between substrate 10 and substrate 40 is that etching stopper 42 of substrate 40 is disposed only between the wiring pattern of active layer 32 and carrier layer 46.

For having the construction disclosed above, the substrate of the present invention can be thinner than any prior art substrates and when packaging, it need not punching or drilling processes. And the result is that it can be used in thin chip packagings. In addition, for being not including plastic materials, the substrate of the present invention would not be deformed as the working temperature is over 200 °C.

## Claims

1. A substrate (10) for thin chip packagings, being **characterized in that** said substrate (10) comprising:
a carrier layer (12) made of a conductive metal sheet with a predetermined thickness;
an etching stopper (14) disposed on a side of said carrier layer (12); and
an active layer (16) made of conductive metal materials and disposed on a free side of said etching stopper (14) in a wiring pattern formed by an etching process operating on said active layer (16).

2. The substrate (10) according to claim 1, being **characterized in that** said substrate (10) further comprises a solder mask layer (34) filled in spaces formed in the wiring pattern of said active layer (16).

3. The substrate according to claim 1, wherein it is **characterized in that** said etching stopper (14) is disposed only between the wiring pattern of said active layer (16) and said carrier layer (12).

4. The substrate (10) according to claim 1, wherein it is **characterized in that** said carrier layer (12) is made of a copper sheet.

5. The substrate (10) according to claim 4, wherein it is **characterized in that** said active layer (16) is made of a copper sheet.

6. The substrate (10) according to claim 4, wherein it is **characterized in that** said etching stopper (14) is made of a nickel sheet.

7. The substrate (10) according to claim 5, wherein it is **characterized in that** said carrier layer (12) is thicker than said active layer (16).

8. A substrate (10) for thin chip packagings, being **characterized in that** said substrate (10) comprises:
a carrier layer (12) made of a copper sheet with a first thickness;
an etching stopper (14) made of a nickel sheet and disposed on a side of said carrier layer (12); and
an active layer (16) made of a copper sheet with a second thickness and disposed on a free side of said etching stopper (14) in a wiring pattern formed by an etching process operating on said active layer (16);
wherein said first thickness is larger than said second thickness.

9. The substrate (10) according to claim 8, wherein it is **characterized in that** the first thickness of said carrier layer (12) ranges from 15 µm to 100 µm.

10. The substrate (10) according to claim 8, wherein it is **characterized in that** the second thickness of said active layer (16) ranges from 9 µm to 18 µm.

11. The substrate (10) according to claim 8, wherein it is **characterized in that** said etching stopper (14) has a thickness ranging from 0.2 µm to 1 µm.
